(19) Europäisches Patentamt
European Patent Office
Office européen des brevets

(11) EP 3 336 471 A1

(12) **EUROPEAN PATENT APPLICATION**

(43) Date of publication:
20.06.2018 Bulletin 2018/25

(51) Int Cl.:
F28D 15/02 (2006.01)        H01L 23/427 (2006.01)
H01L 33/64 (2010.01)        H01S 5/024 (2006.01)
F28D 15/04 (2006.01)        H01L 23/373 (2006.01)

(21) Application number: 17207205.0

(22) Date of filing: 14.12.2017

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD TN

(30) Priority: 14.12.2016 EP 16204106

(71) Applicant: ICOFLEX Sarl
1024 Ecublens (CH)

(72) Inventors:
• BORHANI, Navid
1094 Paudex (CH)

• SOLIGNAC, Dominique
1305 Penthalaz (CH)
• KAEUPER, Peter
1003 Lausanne (CH)
• MOSSIER, Evan
1004 Lausanne (CH)
• ROSSI, Nathanaël
1110 Morges (CH)

(74) Representative: Schneiter, Sorin
Schneiter & Vuille
IP Partners
Ch. de Champ-Colomb 7B
1024 Ecublens (CH)

(54) **ELECTRONICS SUBSTRATES WITH ASSOCIATED LIQUID-VAPOUR PHASE CHANGE HEAT SPREADERS**

(57) The present invention concerns a substrate (1) for electronic components and/or electronics, said substrate (1) comprising one or more channels (4) comprising a cooling fluid (6) of a pulsating heat pipe (PHP) heat exchanger. In a preferred embodiment, the invention provides a passive means of enhancing the in-plane thermal conductivity of an electronics substrate onto which electrical paths have been printed, thus significantly improving the heat spread from and cooling of attached power electronic components. The invention also provides a means of directly cooling thermal and/or electrical vias passing through the electronics substrate.

Figure 1

EP 3 336 471 A1

## Description

## Technical Field

The present invention generally relates to substrates for electronic components. More specifically, the invention relates to a novel substrate for electronic components, the use of the substrate for dissipating waste heat generated by electronic components, a method for cooling electronic components and/or electronics, a substrate for electronic components comprising a heat exchanger, and a self-cooling substrate for electronic components.

## Background Art and Problems Solved by the Invention

The ever-increasing heat fluxes dissipated by high power electronics has led to growing problems related to their thermal management and reliability. Such electronics include light emitting diodes (LED), laser diodes (LD), power amplifiers and converters, micro-processors, insulated-gate bipolar transistors (IGBT) and resonators. The operation of these devices is complicated by the need of keeping their maximum junction temperatures below certain limits to avoid failure, or of maintaining their operating temperatures within certain bands to provide stable repeatable results. Such temperature limits are imposed by the temperature dependent physical properties of semi-conductor materials, the melting point of packaging materials such as solder, and mechanical stresses generated in the package due to the differential thermal expansion of its components.

Such power electronics are typically mounted or packaged on solid substrates fabricated from fibre reinforced plastics, ceramics, glasses and metals onto which the electrical circuit are also printed. The heat that is generated by Joule heating is then conducted away from the device before eventually being removed from the system by forced and/or natural convection and radiation. This can be achieved either by attaching a heat sink to the package and/or by spreading the heat across the substrate through conduction thus allowing it to be more easily convectively cooled. These convection cooling solutions include air cooling, two-phase refrigeration, and thermoelectric cooling.

To build lighter devices with smaller heatsinks, one needs to enhance the spreading of the heat through the substrate by decreasing its thermal resistance. Several solutions have been previously applied: Firstly, rather than standard printed circuit board materials, such as the glass-reinforced epoxy laminate FR-4, the substrate can be made from high thermal conductivity materials. These substrates comprise either single layers or laminates of several materials such as ceramics and metals. Secondly, thermal vias can be constructed through the substrate to locally reduce its thermal resistance. These vias, typically fabricated from high thermal conductivity metals passing through substrates of lower thermal conductivity, are concentrated in areas that experience high heat fluxes on the substrate. On one side they are in contact with the heat generating power electronics and on the other side to a heat sink or high thermal conductivity laminate. These thermal vias are often used to electrically power and control the electronic elements, to provide electrical connections through the substrate, and to facilitate the stacking of multiple substrates to produce three-dimensional 3D electronic packages.

Han et al., "Review of the development of pulsating heat pipe for heat dissipation"; Renewable and Sustainable Energy Reviews 59 (2016) 692-709, is a review article discussing the physics and theoretical concepts underlying the functioning heat pipes (PHPs). PHP are considered to have application in solar cell energy utilization, waste heat recovery, aerospace thermal management and electronics cooling. A flexible, wing-type PHP has been developed for cooling notebook (Fig. 8). Furthermore, bent PHPs were used, in a cooler specifically designed for cooling electronic chips (Fig. 9). PHPs were also used for cooling LED arrays (no. 4.2).

It is an objective of the present invention to provide a platform solution for cooling electronic components, in other words a solution which is suitable independently for different electronic components, differing from the tailor-made solutions proposed in the prior art. It is another objective to allow for cooling for complex electronics, comprising a plurality of identical or different electronic components generating heat that needs to be removed, and for electronics that are surrounded by and function along with other electronic equipment, to which they may be interconnected.

It is also an objective to provide a cooling solution which is versatile, space-efficient, simple and economic.

The present invention addresses the problems depicted above.

## Summary of the Invention

In an aspect, the invention provides a substrate comprising a heat exchange arrangement and/or a heat exchanger.

In an aspect, the invention provides a substrate for electronic components and/or electronics, said substrate comprising one or more channel. The channel is adapted to harbour or receive a cooling fluid.

In an aspect, the invention provides a self-cooling, passively cooling and/or automatically cooling substrate for electronic components.

In an aspect, the invention provides a substrate for one or more electronic component comprising a passively driven, integrated two-phase liquid-vapour heat spreader.

In an aspect, the invention provides a circuit board comprising the substrate of the invention.

In an aspect, the invention provides an electronics device comprising the substrate of the invention.

In an aspect, the invention provides an electronics substrate with an integrated phase change liquid-vapour heat spreader. The integrated heat spreader is arranged so as to enhance the thermal management and cooling of attached high power electronics.

In an aspect, the invention provides the use of the substrate of the invention for achieving one or more selected from the group consisting of: dissipating waste heat generated by electronic components; dissipating heat at a location where heat-sensitive electronic components are provided on a substrate; contributing to maintaining a temperature at a location of an electronic component in the range of the operating temperature of said electronic component; cooling a location on a substrate where a heat generating electronic component is provided.

In an aspect, the invention provides a method for passively driving integrated two-phase liquid-vapour heat spreaders.

In an aspect, the invention provides a method for spreading heat generated by devices and installations by pulsating heat pipes.

In an aspect, the invention provides a method for utilizing heat generated from any heat source, including heat generated by mammal animals or humans.

In an aspect, the invention provides a method for direct convective cooling of thermal and/or electrical vias of an electronic substrate by way of a pulsating heat pipe, in particular as the vias pass through the internal volume of the integrated two-phase liquid-vapour heat spreaders.

In an aspect, the invention provides a method for producing a substrate for electronic components, the method comprising associating a heat exchanger with said substrate.

In an embodiment, said fluid is present as a two-phase fluid comprising preferably a liquid phase and a gaseous phase. Preferably, said fluid is a cooling fluid.

In an aspect, the invention provides a substrate comprising a channel comprising a lumen and a fluid arranged in said lumen so as to be able to circulate, pulsate and/or oscillate, and so as to, upon circulation, pulsating and/or oscillation, exchange and/or spread heat.

In an embodiment, the substrate of the invention comprises at least a first zone or heating zone and a second zone or cooling zone, wherein said fluid is arranged relative to said substrate so as to circulate and/or oscillate and to favour heat exchange between said first and second zones.

In an embodiment, said heat exchanger is a pulsating heat pipe (PHP) heat exchanger.

In an embodiment of the device of the invention, the electrical and/or thermal vias are arranged so they pass through the internal volume of the lumen, thus coming into contact and becoming convectively cooled by the two-phase fluid.

In an aspect, the invention provides a device comprising the substrate of the invention, an electrically driven pump and, optionally, a TEG.

Further aspects and preferred embodiments of the invention are defined herein below and in the appended claims. Further features and advantages of the invention will become apparent to the skilled person from the description of the preferred embodiments given below.

## Brief Description of the Drawings

Figure **1** and **2** schematically show the centre plane and cross section, respectively, of a device according to an embodiment of the invention.

Figure **3** schematically shows a section along line B-B in Figure 1.

## Detailed Description of the Preferred Embodiments

The present invention provides a substrate comprising a heat exchange arrangement and/or a heat exchanger, preferably a pulsating heat pipe (PHP).

For the purpose of the present specification, the term "comprising" and its various grammatical forms is intended to mean "includes, amongst other". It is not intended to mean "consists only of".

The substrate of the invention comprises a heat exchanger and may thus as well be referred to as a device. One of the main functions of the substrate is to serve as a substrate, support or basis allowing the attachment of electronic components, which is why, hereinabove, the invention is generally referred to as a substrate. Another main function of the substrate is the cooling function, which is associated with the substrate, support or basis function.

The substrate is preferably adapted to function as a substrate for electronic components and/or electronics. In an embodiment, said substrate comprises one or more substrate material, which is arranged so as to form at least one substantially even and/or flat surface, suitable for attaching and/or supporting one or more electronic component and electrically conducting paths. In an embodiment, the substrate is or comprises a circuit board. Preferably, the substrate of the invention comprises or is configured to comprise electrical paths, for example printed electrical paths. Preferably, the substrate is constructed and/or arranged such as to enable and/or facilitate the interconnection of electronic components to be provided on the substrate and/or such as to enable and/or facilitate the disposition of interfaces, plugs and the like allowing the connection of said electronic components with other electronic components, power sources and the like that are provided on other substrates, according to the invention or not. Said other components or power sources may be required for the operation of an overall device comprising the substrate of the invention and the electronic components on the substrate.

In an embodiment, the substrate of the invention has a thickness of $\leq 2$ cm, preferably $\leq 0.5$ cm, more preferably $\leq 0.2$ cm. Preferably, said thickness of said substrate is the distance between first and second opposed surfaces of the substrate. Preferably, at least one of said opposed surfaces is adapted to attaching and/or supporting said one or more electronic component. Preferably, the indicated thickness includes the heat exchange arrangement. In another embodiment, the indicated thickness does not include the heat exchange arrangement. The latter may be the case of the heat exchange arrangement is not integrated within the substrate but attached or deposited to a surface of the substrate.

The substrates of the invention may comprise and/or be generally made of material that is typically used for such substrates. For example, electronic components are mounted or packaged on solid substrates fabricated from plastics, fibre reinforced plastics, ceramics, glasses and electrically insulated metals onto which the electrical circuit may also be printed. The substrate of the invention preferably comprises one or a combination of two or more such materials, for example. In a preferred embodiment, the substrates comprise a material selected from the group consisting of aluminium nitride, gallium nitride, silicon carbide, and sapphire. Silicon carbide is preferred. In an embodiment, the substrate comprises one or several of these materials, for example a composition comprising a several of those materials, or different layers/plates comprising different materials. In a preferred embodiment, the substrates comprise or consist of a ceramic material, for example selected from the ones mentioned above.

Preferably, one or both of the substantially opposed surfaces are even and/or smooth surfaces on the macroscopic scale, with the exception of optionally present recesses or through-holes. The latter are generally disposed over the surface or in a limited part of the surface, so that an overall substantially even surface is apparent. In an embodiment, one or both of the substantially opposed surfaces are flat. Generally, substrates for electronic components are flat, such as circuit boards. The invention does not exclude, however, that the surface is curved, for example if a particular application requires a particular, curved, bent or otherwise non-flat shape for the support of the electronic components.

Preferably, the substrate is substantially rigid, having limited flexibility. However, the invention does not exclude flexible substrates, if the channels can be associated with a flexible substrate, in particular if the channels themselves exhibit flexibility.

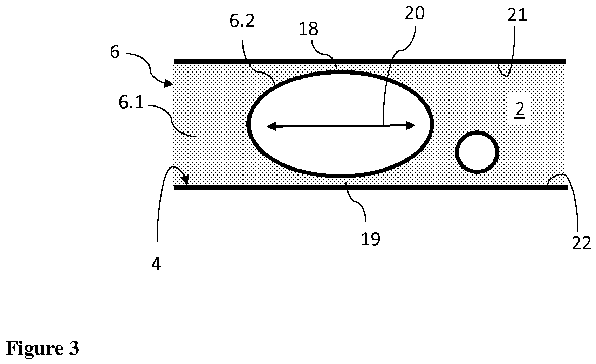

The substrate of the invention comprises a heat exchange arrangement. Preferably the heat exchange arrangement comprises a pulsating heat pipe (PHP). These systems preferably use the heat dissipated by devices to boil a liquid that is held in a closed volume or lumen comprising networks of channels, in particular microchannels. The latent heat of vaporisation involved in this change of phase then efficiently collects the heat. The rapid growth of nucleated vapour bubbles then pushes against the surrounding liquid thus providing passive pumping of the heated liquid coolant and the vapour bubbles around the closed volume (Fig. 3). The vapour bubbles then condense at the colder regions of the lumen and the heated liquid losses its heat to the colder lumen surfaces thus releasing their collected heat. This results in the enhanced convective cooling of the device as well as the spreading the dissipated heat over an extended area.

Preferably, said fluid **6** and/or said one or more channel **4** are configured arranged and/or selected so as to enable the fluid **6** to circulate, pulsate and/or oscillate in said channel **4** and/or lumen **2,** and so as to, upon circulation and/or oscillation, exchange heat. For example, the substrate favours heat exchange between a heat generating electronic component attached to the substrate and the environment. Accordingly, the heat exchanger comprises the channels **4,** the lumen 2 formed by said channels, and the working fluid **6** provided in said lumen.

In an embodiment, said fluid is susceptible of being present as a combination of two phases, a liquid phase and a gaseous phase in said one or more channel. This applies in particular to an operation temperature or temperature range, that is, the temperature of the fluid when the electronic component or device comprising the substrate of the invention is in use.

In an embodiment, the fluid is a dielectric.

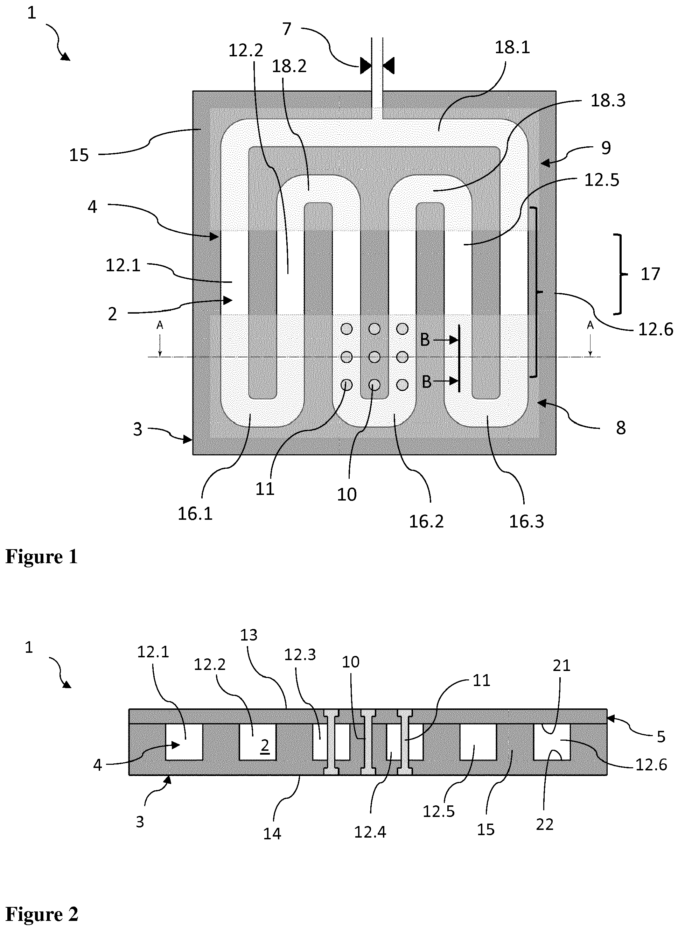

Figures **1** and **2** show an exemplary electronics substrate **1** in accordance with an embodiment of the invention. The internal volume or lumen **2** of the substrate preferably comprises a closed loop pulsating heat pipe defined by a serpentine network of microchannels **4**. These microchannels can either be fabricated by subtractive techniques into the rigid back plate **3,** by additive techniques on top of the back plate, or embossed on to the back plate, for example. A rigid cover plate **5** is bonded to the back plate to hermetically seal the volume of the lumen (Fig. 2).

In the present specification, the term "channel" **4** is generally used to refer to a continuous channel providing a definite, continuous lumen **2.** The terms "channel" and "channel system" are generally used in an equivalent manner and are considered to be the same, unless the context makes a distinction apparent. A channel may comprise a succession of curved and/or straight sections, for example a succession of alternating straight and curved channel sections. A channel may be closed loop or not. If the channel does not form a closed loop, it generally has channel extremities or ends, where the channel or lumen ends. Preferably, during operation of the device, the channel is hermetically sealed, such that the fluid **6** in the channel cannot exit the channel, whether the channel is open or closed loop. As discussed elsewhere in this specification, a channel may be provided with a closable opening **7,** for example for filling and/or changing the working fluid.

In the embodiment, said channel comprises a plurality of channel sections, which are connected so as to form a continuous lumen in which said fluid is provided.

In an embodiment of the method for producing a substrate for electronic components, the method comprises providing a first or back plate, forming grooves and/or precursor channels in said first plate, and attaching a second or cover plate to the first plate, so as to form a channel or channel system. The channel system is preferably formed in and/or between said first and second plates.

In the embodiment shown, precursor channels are formed by a subtractive technique, for example by forming grooves in the back plate **3.** The grooves in the back plate **3** can be considered as precursor channels. The channels **4** are then formed by placing the cover plate **5** so as to cover said grooves and so as to close the top surface of the grooves, thereby creating tunnels or channels, forming a channel system comprising lumen **2,** defined by said grooves. As can be seen in Fig. 2, a lower side of the cover plate **5,** which lower side faces the back plate and is fixed thereto, provides inner surfaces **21** of said channels **4,** in particular inner "top" surfaces, if one considers the top of Fig. 2 to represent the top of the substrate **1.** On the other hand, a bottom surface **22** of the channels **4** is formed by the bottom surface of said grooves.

In an embodiment, said substrate **1** comprises a main plate **3,** comprising one or more channel precursors formed by a subtractive technique, which channel precursors are channels that are at least partially open towards an open side of the main plate **3,** and a cover plate **5** provided on said main plate **3** and closing said one or more channel precursors, thereby forming, together with said main plate **5,** said one or more channel **4.** As can be seen in Fig. 2, a lower side of the cover plate **5,** which lower side faces the back plate and is fixed thereto, provides inner surfaces **21** of said channels **4,** in particular inner "top" surfaces, if one considers the top of Fig. 2 to represent the top of the substrate **1.** On the other hand, a bottom surface **22** of the channels **4** is formed by the bottom surface of said grooves. The cover plate **5** hermetically seals the channels, with the exception of the optional inlet port **7,** which can preferably be sealed separately. In a preferred embodiment, the substrate comprises a main plate **3** and a cover plate **5** made from aluminium nitride, or any other suitable material as disclosed in the present specification, for example. The main plate and cover plate are bonded together using an intermediate solder layer such as gold-tin solder for example.

In accordance with the invention, the channel system formed by said one or more channel **4** is preferably associated with said substrate, preferably forming a unit and/or assembly together. For example, the channel system may be fixed to or integrated in the substrate.

In an embodiment, said substrate **1** comprises one or more substrate material **15,** and wherein said one or more channel **4** are: (i) provided in said one or more substrate material **15,** (ii) provided on said one or more substrate material **15,** (iii) partially or substantially totally embedded in said one or more substrate material **15,** (iv) partially or substantially totally by said substrate material **15,** and/or (v) a combination of one or more of the aforementioned. In an embodiment of the method for producing the invention, the microchannels **4** can be fabricated into an intermediate layer placed between and bonded to both the back **3** and the cover **5** plates, so as to form a channel or channel system. In an embodiment, this intermediate substrate can be preferably made from glass or plastic.

In an embodiment, the substrate comprises a layered structure, comprising two or more, for example three or more layers or sheets. Preferably, the channels and/or lumen are formed in a intermediate layer, which may be covered by back and/or top cover layers. The channels may, for example, be defined as cut-outs or grooves in such an intermediate layer. For example, instead of two layers as shown in Fig. 2, where the back plate contains grooves defining the lumen of the channels, the channels may be defined by cut-outs of an intermediate layer, and a separate back plate, lacking groves or cut-outs defining channels, may be provided.

In an embodiment, an intermediate layer defining channels may be sandwiched between top and bottom layers, one or both of the latter may be arranged so as to cover and hermetically seal the lumen.

In an embodiment, the substrate comprises back and/or cover plates, at least one and preferably both of which comprising or essentially consisting of a material selected from the group comprising aluminium nitride, gallium nitride, silicon carbide and sapphire, or a composition comprising one, two or all four of the aforementioned. The substrate preferably comprises a plastic intermediate layer which incorporates the lumen.

In another preferred embodiment, the substrate comprises back and cover plates comprising a material selected from aluminium nitride, gallium nitride, silicon carbide and sapphire and an intermediate layer comprising glass and/or sapphire, which intermediate layer incorporating the lumen. In yet another embodiment, the intermediate layer is selected, independently from a material as indicated above with respect to the back and/or cover plates.

In a preferred embodiment, the channels **4** of the heat exchanger are integrated inside and/or formed inside the substrate **1,** in particular in an overall matrix **15** formed by the one or more materials of the substrate.

In an embodiment, the channels **4** extend preferably in a plane that is substantially parallel to the plane formed by a surface **13, 14** of the substrate **1.** In an embodiment, the channels forming a heat arrangement are arranged in one plane, preferably a flat plane. The invention does, however, not exclude the possibility of separate, stacked or 3-dimensional channel systems, or of a channel system extending in two or more planes flat planes, or extending in one or more curved planes.

The substrate **1** is preferably fabricated from materials **15** with a high thermal conductivity; these include metals, ceramics, glasses, polymers and composites. The substrate may either comprise a single material or a combination of different materials that have been suitably hermetically bonded. In an embodiment of the invention the material is selected from a material comprising aluminium nitride, gallium nitride, silicon carbide and sapphire ceramic. In order to prevent short circuit of the electrical circuits printed onto the outer surface of the substrate, such surfaces should be fabricated from dielectric materials.

In an embodiment, the substrate comprises a dielectric substrate material **15** and/or at least a surface **13, 14** (Fig. 2) destined for attaching electronic components comprises dielectric areas.

In some embodiments, the present invention **1** provides a rigid device conforming to a curved diabatic surface or fitting within a restricted space.

The pulsating heat pipe channels **4** may also be of open loop design, describe any path geometry, and contain any structural elements such as manifolds, check valves, and pin fins. Furthermore, rather than a single loop covering most of the surface area of the heat exchanger, the design can comprise multiple isolated loops thus allowing the heat spreading to be optimised for a given application. In a preferred embodiment, said channels **4** form at least one loop. In an embodiment, the channels **4** form one or several closed loop channel system.

In an embodiment, said one or more channels **4** form a serpentine network.

In Fig. 1, the fluid **6** is not specifically shown. The fluid, preferably present in liquid and gaseous form, is present and preferably fills the lumen **2** defined by the channels **4**. In Fig. 1, one may consider the lumen **2** to coincide with the fluid **6**.

In an embodiment, said one or more channel **4** has an inner diameter or maximal cross-sectional extension selected such that a surface tension acting upon the liquid phase of said fluid **6** is larger than the force of gravity acting on said liquid phase.

The micro-channels **4** can be of any cross-sectional shape as long as their hydraulic diameter is sufficiently small for the surface tension capillary forces dominate the two-phase fluid dynamics, thus forming confined vapour bubbles and allowing the operation of the pulsating heat pipe. This can be achieved by ensuring that the largest inner diameter $D_{crit}$ of all channels comprising circulating fluid **6** in the device and/or, in another embodiment, the average inner diameter of the channels in the device satisfies the following relationship:

$$D_{crit} \leq 2 \left( \sigma / \left( g \left( \rho_L - \rho_V \right) \right) \right)^{1/2},$$

where $\sigma$ is the liquid-vapour surface tension, $g$ is the gravitational acceleration, $\rho_L$ is the density of the liquid phase, and $\rho_V$ is the density of the vapour phase.

In an embodiment, the inner diameter of the channels of the heat pipe is $\leq 1$ cm, preferably $\leq 5$ mm, more preferably $\leq 3$ mm, even more preferably $\leq 2$ mm, and most preferably $\leq 1$ mm, for example $\leq 0.5$ mm. In an embodiment, the inner diameter of the channels of the heat pipe is $\leq 0.2$ mm.

The internal volume **2** of the electronics substrate is preferably partially filled via a sealable inlet port **7** with a suitable working fluid **6** under a vacuum and hermetically sealed. The strength of this seal is preferably sufficient to withstand the operating pressures in the device and the mechanical fatigue due to the cyclic pressure stresses. The working fluid then segments itself around the device to form a sequence of liquid slugs and confined vapour bubbles. In an embodiment, the working fluid is selected from water, hydrocarbons, refrigerants, alcohols, colloidal suspensions such as nano-fluids, and mixtures comprising two or more of the aforementioned. In a preferred embodiment of the invention, the working fluid is an alcohol, preferably methanol. The internal surfaces of the micro-evaporator may also be functionalised to improve its wettability with the chosen working fluid, thus reducing the probability of dryout of the liquid film and critical heat flux condition at higher heat loads and vertical orientations.

The port **7** may comprise a one-time seal, which cannot be opened without destroying the port and/or the port, or a closure that can be re-opened, for example for changing or removing the working fluid after.

In an embodiment, said fluid **6** has a boiling temperature situated within the range of -100 to +300°C, preferably 10 to 100°C, more preferably 20 to 80°C, most preferably 30 to 50°C.

The electronics substrate **1** preferably comprises heated **8,** cooled **9,** and optional adiabatic zones **17.** As the skilled person understands, the various zones or areas **8, 9, 17** may not necessarily be always delimited in a clear-cut manner, as there may be and generally continuous transitions between the zones as specified in this specification. In Fig. 1, the locations of the heating and cooling zones **8, 9** are indicated by way of slightly shadowed, transparent rectangles, with red and blue coloured tones, respectively.

Figure 3 illustrates the operation principle of the PHP in connection with a substrate 1 of the invention. The working fluid **6** segments itself in the channels **4** of the channel system to form a sequence of liquid slugs **6.1** and confined vapour bubbles **6.2.** The liquid phase **6.1** preferably wets the inner surfaces if the channels **4,** so as to form a film **18, 19** on its surfaces. Due to the presence of the films, the bubbles **6.2** are preferably not in contact with the inner walls **21, 22** of the channels **4.** Large bubbles **6.2** tend to expand and/or shrink along the directions indicated with arrow **20,** thereby causing the oscillation and/or circulation of the fluid **6** in the corresponding, same overall or main direction as indicated with arrow **20.** The oscillating, pulsating, circulating or other motion conducted by the two-phase fluid **6** generally provides the heat exchange function of the heat exchange arrangement.

In an embodiment, a first area or heating zone **8** is preferably adapted to accommodate electronic components generating heat to be dissipated. A second area or cooling zone **9** is preferably arranged to allow cooling of said fluid **6** in said one or more channel **4.** Preferably, the zones or areas **8, 9, 17** can be defined as a surface of said substrate **1.** Preferably, each zone **8, 9, is** preferably a part of the overall surface of the upper and or lower surface **13, 14,** respectively, of the substrate **1.**

Although single zones are shown, the device may be heated and cooled at multiple locations simultaneously across the substrate area or surface. Furthermore, as well as on the top and bottom surfaces, the substrate may be cooled and heated along its edges. The imposed surface heat flux and surface temperature gradients then preferably passively drive the pumping of the two-phase working fluid **6** around the lumen **2.**

In an embodiment, said one or more channel **4** comprises at least one channel section **12.6** extending from said heating zone **8** to said cooling zone **9,** thereby preferably favouring heat exchange between said heating and cooling zones **8, 9** by way of a movement of said fluid **6** in said one or more channel **4.** The substrate **1** according to the embodiment shown in Figs 1 and 2 comprises six (6) channel sections **12.1-12.6** extending each from the heating zone to the cooling zone or vice versa.

In principle, the invention is not limited to a particular number of channel sections, but preferably there are more than one, for example 1-500, preferably 2-200 channel sections, for example.

In an embodiment, said one or more channel sections may be interlinked so as to provide a continuous lumen **2,** for example, or they may be part of separate, non-communicating lumens. For example, the substrate may comprise one or several separate closed loop channel systems, each channel system comprising several channel sections extending between said heating and cooling zones of the substrate.

In an embodiment, said one or more channel **4** comprises two or more, preferably parallel, straight sections **12.1-12.6** and one or more curved section, connecting said one or more straight section.

In the embodiment shown in Figs 1 and 2, the channel system comprises said six channel sections extending between the cooling and the heating zone, and, in the heating zone **8,** three curved channel section, connecting each a pair of adjacent, straight channel sections. In the cooling zone **9,** the two lateral channel sections **12.1** and **12.6** are joined in a channel section comprising curves and a straight section **18.1** extending substantially perpendicular direction with respect to channel sections **12.1-12.6.** The central four straight sections **12.2, 12.3, 12.4, 12.5,** are joined pairwise (**12.2/12.3, 12.4/12.5**) by two curved sections **18.2, 18.3,** respectively. Alternative channel designs can be readily conceived by the skilled person based routine experimentation or application requirements, for example.

In an embodiment, said one or more channel **4,** comprise one or more curved section and one or more straight section, wherein said curved section is preferably provided in a heating zone **8** and/or in a cooling zone **9** of said substrate, and/or where said one or more straight section is provided in an intermediate and/or adiabatic zone provided between and/or connecting said heating and said cooling zones **8, 9.** The fluid **6** will exhibit a net heat uptake in the heating zone **8,** a net heat loss in the cooling zone **9** and no net heat transfer in the intermediate adiabatic zone **17.**

For example, the channel sections connecting or joining the heating and cooling zones (herein "connecting channel section") may extend in substantially straight direction, as shown in the embodiment of channel sections **12.1-12.6** in Figs 1 and 2. Alternatively, said connecting channel sections may also be curved. In an embodiment, the substrate comprises a plurality of channel-sections extending substantially in parallel with each other, as shown for example in Fig. 1. In another embodiment, the channel sections connecting the heat and cooling zones may extend in central to distal direction, for example in a star like manner. For example, the distance between neighbouring connecting channel sections may increase with increasing distance away from a heating zone. In another embodiment, the channels can form branched or bifurcated systems. In yet another embodiment, the cross-sectional shape and area of the channel can change along their lengths.

In the embodiment shown in Figs 1 and 2, the heating and cooling zones **8, 9,** are disposed essentially at opposed ends of the substrate **1.** The invention also encompasses other dispositions of the heating and cooling zones, in addition to or combination with the multiple heating and/or cooling zones mentioned above. For example, the substrate may comprise a central heating zone and distal or lateral cooling zones. For example, one or several cooling zones may be disposed partially or completely around a central heating zone. Furthermore, the invention also encompasses a distally or laterally arranged heating zone and one or more central cooling zones, for example. In general, the present invention is not limited with respect to a particular disposition, orientation, and/or contour of said heating and cooling zones.

As can be seen in Fig. 2, the substrate of the invention preferably comprises first and second, opposed surfaces **13, 14.** The opposed surfaces **13, 14** preferably form surfaces of said substrate **1.** The opposed surfaces **13, 14** preferably provide the major part of the surface of the device. Preferably, the surfaces of lateral, top or bottom sides of the substrate contribute little to the overall surface of the substrate, for example less than half, preferably less than one quarter and more preferably less than 1% of the entire surface of the substrate.

The substrate may comprise one or a plurality of through-holes (not shown) extending from one side **13** to the other, opposed side **14.** The through-holes, unless they are part of vias as described below, are preferably provided such that they do not interfere and/or touch the systems of channels **4** of the substrate. These through-holes preferably pass through entirely solid regions of the substrate. In an embodiment of the invention, holes through the solid volume of the substrate may be provided for reducing the weight of the substrate.

Through holes may also be provided in the substrate during manufacturing of the substrate, for the purpose of providing, generally in a subsequent or separate step, thermally and/or electrically conducting vias **11, 10,** which may or may not contact the lumen of the channels **4.** Through-holes for vias **11** that contact the lumen **2** may pass either through the internal volume of a lumen situated inside the substrate and/or touch the channel walls, so that part of the surface of the via communicates directly with and/or is in direct contact with the lumen **2.**

The substrate of the invention preferably comprises one or more vias **10, 11.** The vias are preferably provided in the cooling zone **9** and/or the heating zone **8.** They may be in both zones. Preferably the cooling zone **9** comprises a plurality of vias. Preferably, the heating zone **8** comprises a plurality of vias. Vias, in particular electrical vias, may also be provided in the intermediate zone **17.**

The vias **10, 11** preferably extend from a surface **13** of the substrate **1** into the substrate, for example into the matrix **15** of the substrate **1.** Preferably, the vias extend through or cross the entire substrate **1,** preferably in a normal/perpendicular direction with respect to the surface **13** of the substrate. Thereby, the vias preferably extend from said first surface **13** to said second surface **14** of the substrate **1.** In another embodiment, the vias do not cross the entire substrate. The vias may extend from a first surface **13** into the matrix, without extending to the second surface **14.** This may apply, for example, in the case of layered substrates.

The thermal and/or electrical vias **10, 11** are preferably provided to locally reduce its thermal resistance and/or electrically power and control the attached and/or integrated electronic elements. In an embodiment of the invention, said one or more via **10, 11** comprise a metal with high thermal and electrical conductivities. In an embodiment of the invention, the thermal and/or electrical vias are preferably made from gold. In another embodiment, the vias are preferably made from copper. Via can either pass through a solid region of the substrate **10** and/or through the internal volume of a lumen inside the substrate **11** thus coming into direct contact with the coolant; as shown in Figs 1 and 2. In another embodiment, said one or more via can cross or touch said one or more channel, such that only a part of said via is in contact with said fluid **6.**

In an embodiment, the substrate **1** comprises one or more electrically and/or thermally conducting via **11,** which extend from a surface **13** of the substrate into the substrate **1** so as to be in contact with a lumen **2** of said channels, thereby allowing heat exchange between the via and said fluid **6.** Preferably, said via **11** is in direct contact with said fluid **6.** The vias may extend between the two opposed surfaces of the substrate.

In an embodiment, the cooling of the attached heat generating electronic sources is enhanced by passing thermal and/or electrical vias **11** through the internal volume of the pulsating heat pipe **4** as defined by the lumen **2.** Therefore, these vias **11** are directly convectively cooled by the circulating fluid **6** thus enhancing heat spread through the substrate.

In order to prevent electrical cross-talk between the electrical vias **10, 11,** either the fluid **6** inside the substrate is preferably a dielectric, and/or the materials of the device **1** are preferably dielectric and/or the vias are preferably electrically isolated. Vias **10, 11** may be electrically isolated, for example by either completely coating their external surface with an insulating material and/or by coating the walls of the surrounding holes with an insulating material. This applies generally to the surfaces that need to be insulated and does preferably not apply to the surface of the via destined to provide an electrical and/or thermal contact.

In an embodiment of the invention, the holes and vias only extend to intermediate locations within the substrate volume **1** without passing through the substrate, thus providing electrical and/or thermal connections to intermediate layers.

In an embodiment, said one or more via **10, 11** has a thickness of $\leq$ 1mm preferably $\leq$ 0.5 mm, more preferably $\leq$ 0.1 mm, and most preferably $\leq$ 0.01 mm. Said thickness values preferably refers to the cross-sectional diameter of the vias, preferably to the mean, maximum or minimum cross-sectional diameter.

In another embodiment of the invention, the heat source may originate from sources such as combustion, chemical reactions, mechanical friction, incident radiation, Joule heating of electronics, or heat generated from a living being, for example a mammal.

Preferably, the described embodiments provide a passive sealed device with no moving parts, thus preferably implying a reliable low maintenance operation. The devices of the invention may be manufactured as thin compact low-weight units which can be easily integrated into systems. Furthermore, due to the nature of pulsating heat pipes, the devices of the invention may preferably be used at any orientation and in low gravity applications. Therefore, the present invention is well suited for cooling applications where autonomous long-term operation of the attached system is desired.

In an embodiment, said electronic component comprises one or more selected from the group consisting of: a light emitting diode (LED), a laser diode (LD), a power amplifier, a microprocessor, an insulated-gate bipolar transistors (IGBT), a high voltage electrical component and a resonator. The precited devices are preferably applications of the present invention.

In an embodiment, the electronic component is selected from power electronics, and/or components of power electronics. In an embodiment, the electronic component comprises one or more selected from the group of a high-frequency switch, a power amplifier, a power switch, a power converter, and an electrical transformer.

The heat exchanger of the present invention is preferably a passive device. Preferably, the heat exchanger is functional in the absence of any pump or, more generally, any energy-requiring driving system, in particular any electrical-energy driven pump, which is arranged so as to actively propels the cooling fluid of the heat exchanger. Preferably, the device is free of externally powered pumps, for example free of electrically driven pumps.

In another less preferred but still encompassed embodiment, the invention encompasses the presence of a pump for transporting the cooling liquid in the heat exchanger. In this particular embodiment, the heat exchanger may be an active device or a facultatively active device, in which the pump may be used accessorily or mandatorily, for example. In a particular embodiment, device comprises a pump, which is driven by electrical energy generated from the waste heat produced by an electronic component. The invention comprises a device comprising a TEG (thermo-electric generator) for producing energy that may be used for driving a pump for actively transporting the cooling fluid in the substrate of the invention. Preferable, the device does not require any external electric energy and is thus autonomous.

As could be shown, the invention provides a passive means of enhancing the in-plane thermal conductivity of an electronics substrate onto which electrical paths have been printed, thus significantly improving the heat spread from and cooling of the attached power electronic components. The invention also provides a means of directly cooling thermal and/or electrical vias passing through the electronics substrate.

While certain of the preferred embodiments of the present invention have been described and specifically exemplified above, it is not intended that the invention be limited to such embodiments. Various modifications may be made thereto without departing from the scope and spirit of the present invention, as set forth in the following claims.

## Claims

1. A substrate (1) for electronic components and/or electronics, said substrate comprising one or more channel (4) comprising a cooling fluid (6).

2. The substrate (1) of claim 1, which comprises a heat exchanger, preferably a pulsating heat pipe.

3. The substrate of any one of claim 1 or 2, wherein, at an operating temperature, said fluid (6) is susceptible of being present as a combination of two phases, a liquid phase and a gaseous phase in said one or more channel (4).

4. The substrate of any one of the preceding claims, wherein said fluid (6) is a dielectric.

5. The substrate (1) of any one of the preceding claims, which comprises a first area or heating zone (8), preferably adapted to accommodate electronic components generating heat to be dissipated, and a second area or cooling zone (9), arranged to allow cooling of said fluid (6) in said channel (4).

6. The substrate (1) of a claim 5, wherein said one or more channel (4) comprises at least one or more channel section (16) extending from said heating zone (8) to said cooling zone (9), thereby preferably favouring heat exchange between said heating and cooling zones (8, 9) by way of a movement of said fluid (6) in said one or more channel (4).

7. The substrate (1) of any one of the preceding claims, wherein said channel (4) comprises a plurality of channel sections (12.1-12.6, 16,1-16.3, 18.1-18.3) which are connected so as to form a continuous lumen (2) in which said fluid (6) is provided.

8. The substrate (1) of any one of the preceding claims, which comprises a dielectric substrate material (15) and/or wherein a surface (13, 14) destined for attaching electronic components comprises dielectric areas.

9. The substrate (1) of any one of the preceding claims, comprising first and second, opposed surfaces (13, 14) and one or more via (10, 11) extending through said substrate (2), from said first to said second surface.

10. The substrate (1) of any one of the preceding claims, comprising one or more electrically and/or thermally conducting via (11), which extend from a surface (13) of the substrate (1) into the substrate (1) so as to be in contact with a lumen (2) of said channels, thereby allowing heat exchange between the via (11) and said fluid (6).

11. The substrate (1) of claim 10, wherein said via (11) is in direct contact with said fluid (6) so as to be directly convectively cooled by said fluid (6).

12. The substrate (1) of any one of claims 9 to 11, wherein said one or more via (10, 11) comprise a conductive metal, and wherein optionally said one or more via (10, 11) are electrically isolated.

13. The substrate (1) of any one of the preceding claims, wherein said one or more channel (4) has an inner diameter or maximal cross-sectional extension selected such that a surface tension acting upon the liquid phase of said fluid (6) is larger than the force of gravity acting on said liquid phase.

14. The substrate (1) of any one of the preceding claims, wherein said substrate (2) comprises one or more substrate material (15), and wherein said one or more channel (4) are:

> - provided in said one or more substrate material (15),
> - provided on said one or more substrate material (15), and,
> - at least partially embedded in said one or more substrate material (15),
> - at least partially surrounded by said substrate material (15), and/or
> - a combination of one or more of the aforementioned.

15. The substrate (1) of any one of the preceding claims, wherein said substrate comprises one or more substrate material (15), which is arranged so as to form at least one substantially even and/or flat surface (13), suitable for attaching and/or supporting one or more electronic component and electrically conducting paths.

**Figure 1**

**Figure 2**

**Figure 3**

Europäisches
Patentamt

European
Patent Office

Office européen
des brevets

# EUROPEAN SEARCH REPORT

Application Number

EP 17 20 7205

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2016/012146 A1 (KONINKL PHILIPS NV [NL]) 28 January 2016 (2016-01-28) * abstract * * figures 1-4,7 * * page 2, line 9 - page 11, line 34 * * page 12, line 33 - page 22, line 17 * ----- | 1-8, 13-15 | INV. F28D15/02 H01L23/427 H01L33/64 H01S5/024 ADD. |
| X | WO 2013/016731 A1 (INTEGRAL LASER SOLUTIONS LLC [US]; UNIV MISSOURI [US]; SCHLIE LAVERNE) 31 January 2013 (2013-01-31) * abstract * * figures 20-42 * * paragraph [0026] - paragraph [0035] * * paragraph [0079] - paragraph [0121] * ----- | 1-8, 13-15 | F28D15/04 H01L23/373 |
| X | US 2013/199770 A1 (CHERIAN GABE [US]) 8 August 2013 (2013-08-08) | 1-3,5-7, 9,12,14, 15 | |
| A | * abstract * * figures 1,8-10,43-51,70,72-75,82-83 * * paragraph [0162] - paragraph [0172] * * paragraph [0250] - paragraph [0285] * * paragraph [0321] - paragraph [0329] * * paragraph [0385] - paragraph [0391] * * paragraph [0408] - paragraph [0413] * ----- | 4,8 | TECHNICAL FIELDS SEARCHED (IPC) F28D H01L H01S |
| X | US 2011/017431 A1 (YANG RONGGUI [US] ET AL) 27 January 2011 (2011-01-27) | 1-6, 10-12, 14,15 | |
| A | * abstract * * figures 1-40 * * paragraph [0006] - paragraph [0020] * * paragraph [0063] - paragraph [0175] * ----- | 8,9 | |
| X | US 2012/106084 A1 (MIZUTA KEI [JP] ET AL) 3 May 2012 (2012-05-03) | 1-7,9, 12,14,15 | |
| A | * the whole document * ----- | 8 | |

The present search report has been drawn up for all claims

| Place of search | Date of completion of the search | Examiner |
|---|---|---|
| The Hague | 24 April 2018 | De Kroon, Arnoud |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 17 20 7205

This annex lists the patent family members relating to the patent documents cited in the above-mentioned European search report.
The members are as contained in the European Patent Office EDP file on
The European Patent Office is in no way liable for these particulars which are merely given for the purpose of information.

24-04-2018

| Patent document cited in search report | | Publication date | Patent family member(s) | | Publication date |
|---|---|---|---|---|---|
| WO 2016012146 | A1 | 28-01-2016 | EP | 3172488 A1 | 31-05-2017 |
| | | | US | 2017205063 A1 | 20-07-2017 |
| | | | WO | 2016012146 A1 | 28-01-2016 |
| WO 2013016731 | A1 | 31-01-2013 | US | 2013044776 A1 | 21-02-2013 |
| | | | WO | 2013016731 A1 | 31-01-2013 |
| US 2013199770 | A1 | 08-08-2013 | NONE | | |
| US 2011017431 | A1 | 27-01-2011 | US | 2011017431 A1 | 27-01-2011 |
| | | | US | 2015226493 A1 | 13-08-2015 |
| | | | US | 2016187070 A1 | 30-06-2016 |
| | | | US | 2017030654 A1 | 02-02-2017 |
| | | | US | 2017299277 A1 | 19-10-2017 |
| US 2012106084 | A1 | 03-05-2012 | CN | 102066864 A | 18-05-2011 |
| | | | JP | 5178274 B2 | 10-04-2013 |
| | | | JP | 2009236362 A | 15-10-2009 |
| | | | KR | 20110028430 A | 18-03-2011 |
| | | | US | 2012106084 A1 | 03-05-2012 |
| | | | WO | 2009119289 A1 | 01-10-2009 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **HAN et al.** Review of the development of pulsating heat pipe for heat dissipation. *Renewable and Sustainable Energy Reviews,* 2016, vol. 59, 692-709